(19) Europäisches Patentamt
European Patent Office
Office européen des brevets

(11) **EP 2 981 834 B1**

(12) **EUROPÄISCHE PATENTSCHRIFT**

(45) Veröffentlichungstag und Bekanntmachung des Hinweises auf die Patenterteilung:
**05.08.2020   Patentblatt 2020/32**

(21) Anmeldenummer: **14716262.2**

(22) Anmeldetag: **31.03.2014**

(51) Int Cl.:
**G01R 15/20** *(2006.01)*        **H02M 1/00** *(2006.01)*

(86) Internationale Anmeldenummer:
**PCT/EP2014/056483**

(87) Internationale Veröffentlichungsnummer:
**WO 2014/161826 (09.10.2014 Gazette 2014/41)**

(54) **STROMWANDLER UND VERFAHREN ZUM WANDELN EINES IN EINEM ELEKTRISCHEN LEITER FLIESSENDEN LEITERSTROMS IN EIN AUSGANGSSIGNAL**

CURRENT TRANSFORMER AND METHOD FOR CONVERTING A CONDUCTOR CURRENT FLOWING IN AN ELECTRICAL CONDUCTOR TO AN OUTPUT SIGNAL

TRANSFORMATEUR DE COURANT ET PROCÉDÉ DE CONVERSION D'UN COURANT CIRCULANT DANS UN CONDUCTEUR ÉLECTRIQUE EN UN SIGNAL DE SORTIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.04.2013   DE 102013103350**

(43) Veröffentlichungstag der Anmeldung:
**10.02.2016   Patentblatt 2016/06**

(73) Patentinhaber: **Weidmüller Interface GmbH & Co. KG**
**32758 Detmold (DE)**

(72) Erfinder:
• **GERKENS, Michael**
  **33617 Bielefeld (DE)**
• **HEGGEMANN, Christian**
  **32758 Detmold (DE)**
• **SCHLINGMANN, Hans**
  **32805 Horn-Bad Meinberg (DE)**

(74) Vertreter: **Kleine, Hubertus**
**Loesenbeck - Specht - Dantz**
**Patent- und Rechtsanwälte**
**Am Zwinger 2**
**33602 Bielefeld (DE)**

(56) Entgegenhaltungen:
**EP-A2- 1 215 504        US-A- 4 639 665**

• **"Current transducer FHS 40-P/SP600 I PM = 0 -100 A Minisens Introduction", , 31. Dezember 2007 (2007-12-31), Seiten 1-18, XP055123111, Gefunden im Internet: URL:http://www.lem.com/docs/products/fhs 40-p sp600.pdf [gefunden am 2014-06-12]**
• **"New Miniaturised Transducers for PCB-based Current Measurement", , 31. Dezember 2007 (2007-12-31), Seiten 1-2, XP055123114, Gefunden im Internet: URL:http://www.power-mag.com/pdf/feature_p df/1222952887_PEE_Issue_2_2007_Current_Tra nsducers-New_Miniaturised_Transducers_for_ PCB-based_Current_Measurement.pdf [gefunden am 2014-06-12]**
• **"CAS / CASR / CKSR series Current Transducers. Insulated Highly Accurate Measurements from 1.5 to 50 Arms", , 28. Februar 2009 (2009-02-28), Seiten 1-24, XP055123116, Gefunden im Internet: URL:http://www.digikey.nl/Web Export/Supplier Content/LEM_398/PDF/LEM_CAS_CASR_CKSR. pdf? redirected=1 [gefunden am 2014-06-12]**
• **ANONYMOUS: "LEM: Railway Current & Voltage Transducers", INTERNET CITATION, 1 January 2007 (2007-01-01), pages 1-44, XP002695768, Retrieved from the Internet: URL:http://www.amds4.com.br/web/img/CH2610 1_E%282%29.pdf [retrieved on 2013-04-18]**

EP 2 981 834 B1

**Beschreibung**

Die vorliegende Erfindung betrifft einen Stromwandler mit einem Stromsensor zur Bestimmung eines Effektivwerts eines Leiterstroms. Die Erfindung betrifft weiterhin ein Verfahren zum Wandeln eines in einem elektrischen Leiter fließenden Leiterstroms in ein Ausgangssignal.

Stromwandler werden zur Messung eines meist großen durch einen Leiter fließenden Leiterstroms verwendet. Sie liefern ein Ausgangssignal - entweder ein Ausgangsspannungssignal oder ein Ausgangsstromsignal -, das linear zu dem zu messenden Leiterstrom ist.

Es sind Stromwandler bekannt, bei denen der zu messende Leiterstromkreis mit dem Ausgangsstromkreis mittels eines beide Stromkreise durchsetzenden magnetisch leitenden (Eisen-) Kerns gekoppelt ist. Bei einem sich ändernden Strom im zu messenden Stromkreis ändert sich das von dem Leiterstrom verursachte Magnetfeld in dem Kern. Dadurch wird im Ausgangsstromkreis eine Spannung induziert, die erfasst wird. Die Stromerfassung über Induktion lässt jedoch nur die Erfassung von Wechselströmen im zu messenden Stromkreis zu.

Im Gegensatz dazu sind mit Stromwandlern, die mit Stromsensoren, beispielsweise Hallsensoren oder Shunt-Widerständen, arbeiten, auch Gleichströme erfassbar. Ein Hallsensor wird dabei beispielsweise in einem von dem zu messenden Leiterstrom verursachten Magnetfeld positioniert, und der magnetische Fluss des Magnetfeldes erfasst. Nach einer ggf. notwendigen Offsetkorrektur ist eine von dem Hallsensor abgegebene Ausgangsspannung proportional zu dem magnetischen Fluss und damit dem Leiterstrom. Eine solche Messung wird beispielsweise mit einer Stromzange durchgeführt, die den Leiter umfasst, der von dem Strom durchflossen ist. Im Fall eines Shunt-Widerstands als Stromsensor wird der Shunt unmittelbar von dem zu messenden Leiterstrom durchflossen und die an ihm abfallende Spannung gemessen. Als Stromsensoren geeignete Hallsensoren werden beispielsweise von der Firma LEM unter der Produktbezeichnung FHS 40-P/SP600 angeboten. Ein Datenblatt dieser Hallsensoren ist unter der Internetadresse "http://www.lem.com/docs/products/fhs40-p sp600.pdf" verfügbar. Weitere Hallsensoren sind unter der Internetadresse "http://www.amds4.com. br/web/img/ CH26101_E%282%29.pdf" verfügbar.

Die vom Stromsensor abgegebene Ausgangsspannung ist vorzeichenbehaftet, wobei das Vorzeichen die Stromrichtung angibt. Bei Stromwandlern, die zur Messung von Wechselströmen eingerichtet sind, wird ein Effektivwert (RMS - Root Mean Square, quadratischer Mittelwert) der Ausgangsspannung des Stromsensors gebildet und so ein zu dem Effektivwert des Leiterstroms lineares Ausgangssignal abgegeben.

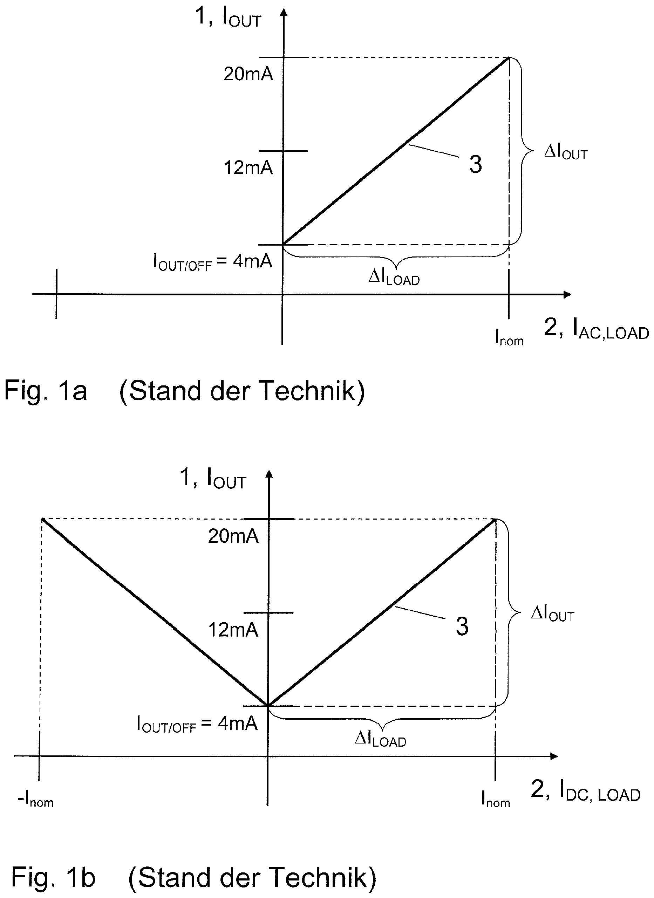

Die Fig. 1 (a) zeigt eine Übertragungskennlinie 3 eines solchen Stromwandlers für Wechselstrom (AC - Alternating Current) nach dem Stand der Technik. Auf der x-Achse ist der Leiterstromwert $I_{AC,LOAD}$ in Ampere (A) aufgetragen, auf der y- Achse als Ausgangssignal ein Ausgangsstromwert $I_{OUT}$ in Milliampere (mA). Der Ausgangsstrom ist dem Effektivwert des Leiterstroms $I_{AC,LOAD}$, der das Magnetfeld in einem Hallsensor verursacht, mit einem Skalierungsfaktor $k = \Delta I_{OUT} / \Delta I_{AC,LOAD}$ proportional. Zudem ist dem Ausgangsstrom ein Offset-Wert $I_{AC,OUT/OFF}$ überlagert, so dass bei einem Leiterstrom von OA ein messbarer Ausgangsstrom von hier 4mA fließt.

Aufgrund der Effektivwertbildung arbeiten derartige Stromwandler unipolar. Die Messung eines Gleichstroms (DC - Direct Current) $I_{DC,LOAD}$ als Leiterstrom liefert daher immer ein positives Ausgangssignal, unabhängig von der Stromrichtung des Leiterstroms. Eine entsprechende Kennlinie, in der als Ausgangssignal ebenfalls ein Ausgangsstrom gewählt ist, zeigt die Fig. 1(b).

Daneben sind Stromwandler zur Messung von Gleichströmen bekannt, bei denen sich die Richtung des Gleichstroms in dem Ausgangssignal niederschlägt. Solche Wandler werden auch als bipolar arbeitende Stromwandler bezeichnet. Mit diesen Wandlern ist allerdings eine Messung von Wechselströmen nicht möglich. Je nach Reaktionszeit des Stromwandlers führt ein im Leiter fließender Wechselstrom entweder zu einem Ausgangssignal, das einer Stromstärke von Null entspricht oder zu einem mit der Frequenz des Wechselstroms alternierenden Ausgangssignal.

Aufgabe der Erfindung ist es, einen Stromwandler mit einem Stromsensor zu schaffen, der sich sowohl für eine Stromwandlung eines eingangsseitig fließenden Wechselstroms als auch eines eingangsseitig fließenden Gleichstroms als auch eines Mischstroms eignet, und bei dem die Stromrichtung des eingangsseitig fließenden Gleichstroms erkennbar ist.

Die Aufgabe wird gelöst mit einem Stromwandler gemäß Anspruch 1 und einem Verfahren gemäß Anspruch 10. Vorteilhafte Ausführungsformen sind den Unteransprüchen zu entnehmen.

Ein erfindungsgemäßer Stromwandler weist einen Stromsensor auf, der einen Leiterstrom, der in einem elektrischen Leiter fließt, in eine dem Leiterstrom proportionale Ausgangsspannung wandelt. Der Stromwandler zeichnet sich dadurch aus, dass er einen ersten Verarbeitungszweig umfasst, in dem ein Mittel zur Berechung des Effektivwertes der Ausgangsspannung vorgesehen ist, sowie einen zweiten Verarbeitungszweig, in dem ein Mittel zur Erfassung einer Polarität der Ausgangsspannung vorgesehen ist. Der Stromwandler ist dazu eingerichtet, den Effektivwert abhängig von der erfassten Polarität der Ausgangsspannung des Stromsensors mit einem positiven oder negativen Faktor zu multiplizieren, wobei bei einem reinen Wechselstrom als Leiterstrom ebenfalls der positive Faktor gewählt wird, und den vorzeichenbehafteten Effektivwert als Ausgangssignal auszugeben.

Durch die unabhängige Erfassung von Effektivwert und Polarität eignet sich der Stromwandler sowohl für die Erfassung eines in dem elektrischen Leiter fließenden Wechselstroms, als auch für die Erfassung einer Richtung eines in dem elektrischen Leiter fließenden Gleichstroms.

Der erste Verarbeitungszweig umfasst bevorzugt ein erstes Frequenzfilter. Vorzugsweise filtert das erste Frequenzfilter hochfrequente Störsignale aus, und weist daher eine hohe Eckfrequenz auf. Besonders bevorzugt ist der Frequenzbereich des ersten Frequenzfilters einstellbar. Es ist daher einstellbar, ob das Mittel zur Erfassung des Effektivwertes der Ausgangsspannung für eine Effektivwertmessung, die im Wesentlichen sinusförmige Wechselströme erfasst, oder für eine Echt-Effektivwertmessung, die auch verzerrte Wechselströme erfasst, verwendet wird.

Ebenfalls bevorzugt umfasst der zweite Verarbeitungszweig ein zweites Frequenzfilter. Das zweite Frequenzfilter ist bevorzugt zum Glätten des Ausgangssignals vorgesehen. Vorzugsweise filtert es nicht nur hochfrequente sondern auch niederfrequente Frequenzanteile in der Größenordnung der Netzfrequenz von 50 - 60Hz aus. Dem Mittel zur Erfassung der Richtung des Ausgangssignals wird daher ein gefiltertes Ausgangssignal zur Verfügung gestellt, aus dem der Wechselstromanteil im Leiterstrom herausgefiltert ist.

Zur Verarbeitung von Mischströmen wird der mit dem Mittel zur Berechung des Effektivwertes der Ausgangsspannung berechnete Effektivwert abhängig von der Polarität der Ausgangsspannung mit einem positiven oder negativen Faktor, beispielsweise +1 oder -1, multipliziert. Dabei ist das Mittel zur Erfassung einer Polarität der Ausgangsspannung so eingerichtet, dass es einem reinen Wechselstrom als Leiterstrom eine positive Polarität signalisiert. Entsprechend wird dann ein Faktor von +1 auf den Effektivwert multipliziert.

Weiterhin ist es bevorzugt, den vorzeichenbehafteten Effektivwert in einer Ausgabeschaltung in das Ausgangssignal zu wandeln. Als Ausgangssignal ist eine Spannung oder ein Strom bevorzugt.

Die Ausgabeschaltung umfasst bevorzugt ein Mittel zum Addieren eines Offset-Wertes und/oder ein Mittel zum Skalieren des Ausgangssignals. Es können noch weitere Anpassungen des Ausgangssignals vorgesehen sein, beispielsweise Frequenzfilter oder ähnlich.

Sofern dem vorzeichenbehafteten Effektivwert ein Offset-Wert addiert wird, ist das Ausgangssignal bei einem in dem elektrischen Leiter fließenden Leiterstrom von 0A der Offset-Wert.

Und aufgrund der Erfassung der Polarität der Ausgangsspannung ist der Ausgangsstrom bei in negativer Richtung fließendem Gleichstromanteil des Leiterstroms kleiner als der Offset-Wert und bei in positiver Richtung fließendem Gleichstromanteil des Leiterstroms größer als der Offset-Wert.

Besonders bevorzugt ist der Offset-Wert größer als die Hälfte eines abzubildenden Wertebereiches. Ist der Leiterstrom beispielsweise auf einen Ausgangsstrom im Wertebereich von -8mA ≤ $I_{OUT}$ ≤ +8mA abzubilden, ist es bevorzugt, einen Offset-Wert zu verwenden, der größer als 8mA ist. Besonders bevorzugt wird dem halben abzubildenden Wertebereich ein Grundwert addiert. Bei dem genannten Wertebereich beträgt der Grundwert beispielsweise 4mA und der Offset-Wert dann 12mA. Dadurch ist das Ausgangssignal positiv.

Bei einem erfindungsgemäßen Verfahren zum Wandeln eines in einem elektrischen Leiter fließenden Leiterstroms in ein Ausgangssignal, wobei zur Erfassung des Leiterstroms ein Stromsensor genutzt wird, wird der Effektivwert der Ausgangsspannung des Stromsensors berechnet und die Polarität der Ausgangsspannung des Stromsensors erfasst,

- der berechnete Effektivwert abhängig von der der erfassten Polarität mit einem positiven oder einem negativen Faktor zu einem vorzeichenbehafteten
- Effektivwert multipliziert, wobei bei einem reinen Wechselstrom als Leiterstrom ebenfalls der positive Faktor gewählt wird, und
- ein dem vorzeichenbehafteten Effektivwert entsprechendes Ausgangssignal ausgegeben.

Der so berechnete vorzeichenbehaftete Effektivwert ist in seinem Absolutwert dem im elektrischen Leiter fließenden Leiterstrom proportional. Der vorzeichenbehaftete Effektivwert wird bevorzugt skaliert als Ausgangssignal des Stromwandlers ausgegeben, das heißt mit einem Skalierungsfaktor multipliziert, und/oder mit einem aufaddierten Offset-Wert.

In einer bevorzugten Ausführungsform wird der skalierte und/oder mit dem Offset-Wert überlagerte vorzeichenbehaftete Effektivwert als Ausgangssignal des Stromwandlers ausgegeben. In dieser Ausführungsform ist das Ausgangssignal eine Ausgangsspannung. Alternativ wird der skalierte und/oder mit dem Offset-Wert überlagerte vorzeichenbehaftete Effektivwert wird in einen Ausgangsstrom gewandelt und ausgegeben.

Nachfolgend wird die Erfindung unter Bezug auf die Zeichnungen anhand von Ausführungsbeispielen näher erläutert, wobei weitere Vorteile der Erfindung deutlich werden.

Es zeigen:

Fig. 1a, b    jeweils eine Übertragungskennlinie eines Stromwandlers nach dem Stand der Technik, und zwar in Fig. 1a für einen zu messenden Wechselstrom und in Fig. 1b für einen zu messenden Gleichstrom,

Fig. 2    die Übertragungskennlinie eines erfindungsgemäßen Stromwandlers, und

Fig. 3    einen schematischen Aufbau eines erfindungsgemäßen Stromwandlers.

Die Fig. 1 ist oben bereits beschrieben.

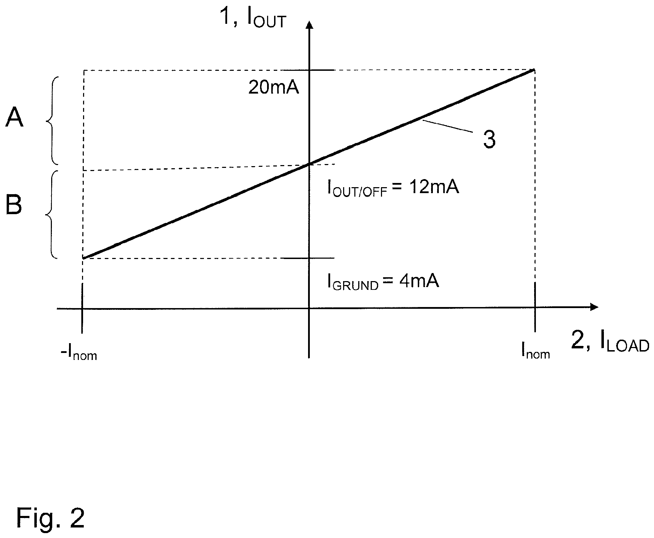

Die Fig. 2 zeigt eine Übertragungskennlinie 3 eines erfindungsgemäßen Stromwandlers 100. Auf der x- Achse ist der Leiterstrom 1, $I_{LOAD}$ in Ampere (A) aufgetragen, auf der y- Achse als Ausgangssignal 2 ein Ausgangsstrom 2, $I_{OUT}$ in Milliampere (mA). Der Ausgangsstrom 2, $I_{OUT}$ ist einem Effektivwert des Leiterstroms 1, $I_{LOAD}$ proportional. Er ist in analoger Weise zu dem Ausgangsstromwert 2, $I_{OUT}$ des aus dem Stand der Technik bekannten Stromwandlers (vgl. Fig. 1(a)) mit dem Skalierungsfaktor $k = \Delta I_{OUT} / \Delta I_{LOAD}$ gewichtet. Zudem ist dem Ausgangsstrom 2, $I_{OUT}$ ebenfalls ein Offset-Wert 6, $I_{OUT/OFF}$ überlagert, so dass bei einem Leiterstrom 1, $I_{LOAD}$ von 0A ein messbarer Ausgangsstrom 2, $I_{OUT}$ fließt.

Der Offset-Wert 6, $I_{OUT/OFF}$ setzt sich hier aus einem Grundwert $I_{GRUND}$ zusammen, der hier beispielhaft dem Offset-Wert 6 eines herkömmlichen Stromwandlers (s. Fig. 1 (a)) von 4 mA entspricht, zuzüglich dem halben abzubildenden Wertebereich:

$$I_{OUT/OFF} = I_{GRUND} + 8mA = 12mA$$

Der Leiterstrom 1, $I_{LOAD}$ wird daher auf einen Ausgangsstrom 2, $I_{OUT}$ folgendermaßen abgebildet:

$$I_{OUT} = 12mA + k * I_{LOAD/RMS}$$

sofern $I_{LOAD}$ ein Wechselstrom ist, oder ein in positiver Richtung fließender Gleichstrom, wie in einem ersten Bereich A dargestellt ist, und

$$I_{OUT} = 12mA - k * I_{LOAD/RMS}$$

sofern $I_{LOAD}$ ein in negativer Richtung fließender Gleichstrom ist (vgl. zweiter Bereich B).

Der erfindungsgemäße Stromwandler 100 arbeitet somit für einen Gleichstrom als Leiterstrom bipolar und ist gleichzeitig in der Lage, einen Effektivwert für einen Wechselstrom als Leiterstrom anzugeben. Die gesamte Information (Effektivwert und das Vorzeichen bei einem Gleichstrom) wird dabei in einem Ausgangssignal ausgegeben und kann so beispielsweise durch einen einzigen Analog/DigitalWandler einer Automatisierungssteuerung erfasst werden.

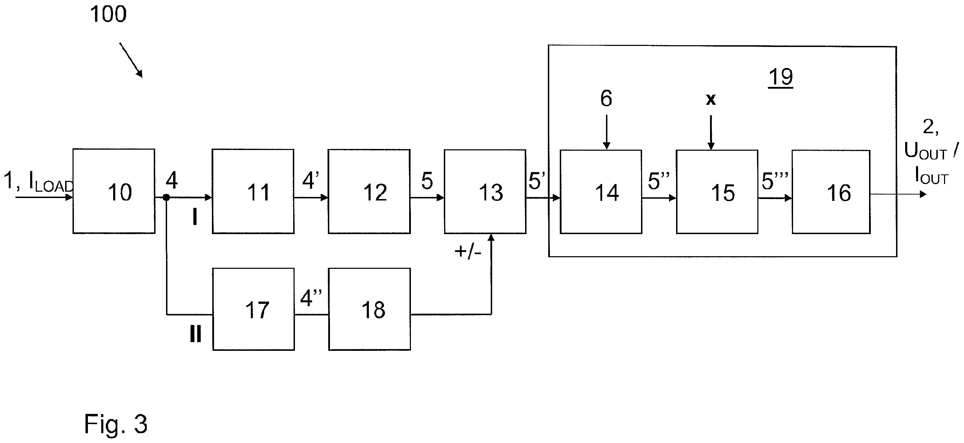

In der Fig. 3 ist der Stromwandler 100 schematisch gezeigt. Er umfasst hier einen Hallsensor 10 zur Erfassung des Leiterstroms 1, $I_{LOAD}$ als Stromsensor. Am Ausgang des Hallsensors 10 wird eine Ausgangsspannung 4 gemessen, die das vom Leiterstrom 1, $I_{LOAD}$ verursachte Magnetfeld im Hallsensor 10 erzeugt. Die Ausgangsspannung 4 ist vorzeichenbehaftet. In einer alternativen Ausgestaltung kann als Stromsensor auch ein Shunt-Widerstand eingesetzt werden, der von dem Leiterstroms 1, $I_{LOAD}$ durchflossen wird. Der Spannungsabfall am Shunt-Widerstand stellt dann die vorzeichenbehaftete Ausgangsspannung 4 dar.

Der Stromwandler 100 weist zwei parallel zueinander angeordnete Verarbeitungszweige I, II auf.

Im ersten Verarbeitungszweig I ist ein Mittel 12 zur Berechnung des Effektivwertes 5 der Ausgangsspannung 4 des Hallsensors 10 vorgesehen. Um Störsignale ausfiltern zu können, ist dem Mittel 12 zur Berechnung des Effektivwertes 5 der Ausgangsspannung 4 optional ein erstes Frequenzfilter 11 vorgeschaltet, vorzugsweise ein Tiefpassfilter mit hoher Eckfrequenz. Die Eckfrequenz des ersten Frequenzfilters 11 und/oder seine Sprungantwortzeit sind optional einstellbar. Dadurch ist vom Anwender wählbar, ob mit dem im ersten Verarbeitungszweig I gefilterten Ausgangssignal 4' im Wesentlichen sinusförmig ausgebildete Wechselströme, oder auch verzerrte Wechselströme erfasst werden. Weiter kann vorgesehen sein, dass eine bei dem Mittel 12 zur Berechnung des Effektivwertes 5 eingesetzte Zeitkonstante einstellbar ist. Durch Wahl einer kurzen Zeitkonstante können Effektivwerte mit einer hohen Änderungsrate ausgegeben werden, allerdings bleiben dann tiefere Frequenzen der Ausgangsspannung 4 bei der Bestimmung des Effektivwertes unberücksichtigt. Umgekehrt kann durch Wahl einer längeren Zeitkonstante sichergestellt werden, dass auch tiefere Frequenzen in die Bestimmung des Effektivwertes eingehen, jedoch reagiert die Ausgabe des Effektivwertes entsprechend träge auf Änderungen.

Im zweiten Verarbeitungszweig II ist ein Mittel 18 zur Erfassung der Polarität +/der Ausgangsspannung 4 vorgesehen. Die erfasste Polarität wird als ein Signal ausgegeben, dem der Wert +1 oder -1 zugeordnet ist. Das Mittel 18 ist so ausgebildet, dass bei einem (reinen) Wechselstrom als Leiterstrom 1 der Wert +1 ausgegeben wird. Dem Mittel 18 zur Erfassung der Polarität +/- der Ausgangsspannung 4 ist ein zweites Frequenzfilter 17 vorgeschaltet, das das Ausgangssignal 4 glättet. Dadurch enthält das geglättete Ausgangssignal 4' das Vorzeichen eines im Leiterstrom 1, $I_{LOAD}$ enthaltenen Gleichstromanteils und nicht das Vorzeichen eines im Leiterstrom 1, $I_{LOAD}$ enthaltenen Wechselstromanteils.

Der im ersten Verarbeitungszweig I berechnete Effektivwert 5 wird abhängig von der im zweiten Verarbeitungszweig II erfassten Polarität +/- mit einem Faktor von +1 oder -1 in einem Multiplizierer 13 multipliziert, beispielsweise mit einem Faktor von +1, wenn eine positive Polarität erfasst wird und einem Faktor von -1, wenn eine negative Polarität erfasst wird.

Der Stromwandler 100 eignet sich so nicht nur für die Erfassung eines reinen Wechselstroms als Leiterstrom 1, $I_{LOAD}$ oder eines reinen Gleichstroms als Leiterstrom 1, $I_{LOAD}$. Er ist auch für die Erfassung von Mischströmen als Leiterstrom 1, $I_{LOAD}$ geeignet, die sowohl einen Gleichstromanteil als auch einen Wechselstromanteil aufweisen. Bei einem reinen Wechselstrom als Leiterstrom 1, $I_{LOAD}$ wird der Leiterstrom 1, $I_{LOAD}$ in dem ersten Bereich A der in Fig. 2 dargestellten Übertragungskennlinie 3 abgebildet.

Um den vorzeichenbehafteten Effektivwert 5' in einer für den Anwender geeigneten Art und Weise ausgeben zu können, umfasst der Stromwandler 100 zudem eine Ausgabeschaltung 19.

Die Ausgabeschaltung 19 umfasst einen Addierer 14, der dem gewichteten Effektivwert 5' einen Offset-Wertes $I_{OUT/OFF}$ überlagert. Die Überlagerung des Offset-Wertes 6 und der Betrag des Offset-Wertes 6 sind optional vom Anwender einstellbar. Zudem umfasst die Ausgabeschaltung 19 ein Mittel 15 zum Skalieren des vorzeichenbehafteten und gegebenenfalls mit dem Offset-Wert 6 überlagerten Effektivwertes 5''. Auch der Skalierungsfaktor k ist optional vom Anwender einstellbar.

Zudem ist einstellbar, ob der vorzeichenbehaftete und gegebenenfalls mit dem Offset-Wert 6 überlagerte und/oder mit dem Skalierungsfaktor k skalierte Effektivwert 5''' in Form eines Ausgangs- Stromsignals 2, $I_{OUT}$ oder eines AusgangsSpannungssignals 2, $U_{OUT}$ ausgegeben wird. Dafür umfasst die Ausgabeschaltung 19 eine vom Anwender anpassbare Ausgangsschaltung 16.

**Bezugszeichenliste**

| | |
|---|---|
| 1 | Leiterstrom |
| 2 | Ausgangsstrom |
| 3 | Übertragungsfunktion |
| 4 | Ausgangsspannung des Stromsensors |
| 4' | Gefilterte Ausgangsspannung im ersten Verarbeitungszweig |
| 4'' | Gefilterte Ausgangsspannung im zweiten Verarbeitungszweig |
| 5 | Effektivwert der Ausgangsspannung |
| 5' | Vorzeichenbehafteter Effektivwert |
| 5'' | Vorzeichenbehafteter und gegebenenfalls mit einem Offset-Wert überlagerter Effektivwert |
| 5''' | Vorzeichenbehafteter, gegebenenfalls mit einem Offset-Wert überlagerter und gegebenenfalls skalierter Effektivwert |
| 10 | Hallsensor |
| 11 | Frequenzfilter im ersten Verarbeitungszweig |
| 12 | Mittel zur Berechung des Effektivwertes der Ausgangsspannung |
| 13 | Multiplikator |
| 14 | Addierer |
| 15 | Anpassungsschaltung |
| 16 | Ausgangsschaltung |
| 17 | Frequenzfilter im zweiten Verarbeitungszweig |
| 18 | Mittel zur Erfassung der Polarität der Ausgangsspannung |
| 19 | Ausgabeschaltung |
| 100 | Stromwandler |
| $I_{OUT}$ | Ausgangsstrom |
| $I_{LOAD}$ | Leiterstrom |
| $I_{AC,LOAD}$ | Leiterstrom (Wechselstrom) |
| $I_{DC,LOAD}$ | Leiterstrom (Gleichstrom) |
| 6, $I_{OUT/OFF}$ | Offset-Wert |
| $I_{GRUND}$ | Grundwert |
| $\Delta I_{OUT}$ | Änderung des Ausgangsstroms |
| $\Delta I_{LOAD}$ | Änderung des Leiterstroms |
| $I_{nom}$ | Nominalwert des Leiterstroms |
| I | Erster Verarbeitungszweig |
| II | Zweiter Verarbeitungszweig |
| A | Erster Bereich |
| B | Zweiter Bereich |

**Patentansprüche**

**1.** Stromwandler (100), umfassend einen Stromsensor, welcher vorgesehen ist, um einen Leiterstrom (1, $IL_{OAD}$), der in einem elektrischen Leiter fließt, in eine dem Leiterstrom (1, $I_{LOAD}$) proportionale Ausgangsspannung (4) zu wandeln, **dadurch gekennzeichnet, dass** der Stromwandler (100) einen ersten Verarbeitungszweig (I) umfasst, in dem ein Mittel (12) zur Berechnung des Effektivwertes (5) der Ausgangsspannung (4) vorgesehen ist, sowie einen zweiten Verarbeitungszweig (II), in dem ein Mittel (18) zur Erfassung einer Polarität (+/-) des Gleichstromanteils der Ausgangsspannung (4) vorgesehen ist, wobei der Stromwandler (100) dazu eingerichtet ist, den Effektivwert (5) abhängig von der erfassten Polarität (+/-) der Ausgangsspannung (4) des Stromsensors mit einem positiven oder negativen Faktor zu multiplizieren, wobei bei einem reinen Wechselstrom als Leiterstrom (1, $I_{LOAD}$) ebenfalls der positive Faktor gewählt wird, und den vorzeichenbehafteten Effektivwert (5') als Ausgangssignal (2, $U_{OUT}$ / $I_{OUT}$) auszugeben.

**2.** Stromwandler (100) nach Anspruch 1, **dadurch gekennzeichnet, dass** der erste Verarbeitungszweig (I) ein erstes Frequenzfilter (11) umfasst, insbesondere zum Filtern hochfrequenter Störsignale.

**3.** Stromwandler (100) nach einem der vorherigen Ansprüche, **dadurch gekennzeichnet, dass** der zweite Verarbeitungszweig (II) ein zweites Frequenzfilter (17) umfasst, insbesondere zum Glätten des Ausgangssignals (4).

**4.** Stromwandler (100) nach einem der vorherigen Ansprüche, **dadurch gekennzeichnet, dass** er eine Ausgabeschaltung (19) zum Wandeln des vorzeichenbehafteten Effektivwertes (5') in das Ausgangssignal (2, $U_{OUT}$ / $I_{-OUT}$) umfasst.

**5.** Stromwandler (100) nach einem der vorherigen Ansprüche, **dadurch gekennzeichnet, dass** das Ausgangssignal (2, UOUT / IOUT) ein Spannungssignal oder ein Stromsignal ist.

**6.** Stromwandler (100) nach Anspruch 4 oder 5, **dadurch gekennzeichnet, dass** die Ausgabeschaltung (19) ein Mittel (14) zum Addieren eines Offset-Wertes (6, $I_{OUT/OFF}$) und/oder ein Mittel (15) zum Skalieren des Ausgangssignals (2, $U_{OUT}$ / $I_{OUT}$) umfasst.

**7.** Stromwandler (100) nach Anspruch 6, **dadurch gekennzeichnet, dass** der Offset-Wert (6, $I_{OUT/OFF}$) größer als die Hälfte eines abzubildenden Wertebereiches ist.

**8.** Stromwandler (100) nach einem der vorherigen Ansprüche, bei dem eine bei der Berechnung des Effektivwertes (5) in dem Mittel (12) eingesetzte Zeitkonstante einstellbar ist.

**9.** Stromwandler (100) nach einem der vorherigen Ansprüche, bei dem der Stromsensor ein Hallsensor (10) oder ein Shunt-Widerstand ist.

**10.** Verfahren zum Wandeln eines in einem elektrischen Leiter fließenden Leiterstroms (1, $I_{LOAD}$) in ein Ausgangssignal (2, $U_{OUT}$ / $I_{OUT}$), durch die Verwendung von einem Stromwandler (100) umfassend einen Stromsensor, wobei zur Erfassung des Leiterstroms (1, $I_{LOAD}$) und zur Umwandlung des Leiterstroms (1, $I_{LOAD}$) in eine proportionale Ausgangsspannung (4) der Stromsensor genutzt wird, wobei der Stromwandler (100)

   - den Effektivwert (5) der Ausgangsspannung (4) des Stromsensors berechnet,
   - die Polarität (+/-) des Gleichstromanteils der Ausgangsspannung (4) des Stromsensors erfasst, und
   - den berechneten Effektivwert (5) abhängig von der der erfassten Polarität (+/-) mit einem positiven oder einem negativen Faktor zu einem vorzeichenbehafteten Effektivwert (5') multipliziert, wobei bei einem reinen Wechselstrom als Leiterstrom (1, $I_{LOAD}$) ebenfalls der positive Faktor gewählt wird, und
   - ein dem vorzeichenbehafteten Effektivwert (5') entsprechendes Ausgangssignal (2, $U_{OUT}$ / $I_{OUT}$) ausgegeben wird.

**11.** Verfahren nach Anspruch 10, **dadurch gekennzeichnet, dass** der vorzeichenbehafteten Effektivwert (5') zur Bestimmung des Ausgangssignals (2, $U_{OUT}$ / $I_{OUT}$) skaliert wird, und/oder dem vorzeichenbehafteten Effektivwert (5') ein Offset-Wert (6, $I_{OUT/OFF}$) aufaddiert wird.

**Claims**

**1.** Current transformer (100), comprising a current sensor, which is designed to convert a conductor current (1, $I_{LOAD}$), flowing in an electrical conductor, into an output voltage (4) proportional to the conductor current (1, $I_{LOAD}$), **characterized in that** the current transformer (100) comprises a first processing branch (I) in which a means (12) is provided for calculating the effective value (5) of the output voltage (4), as well as a second processing branch (II) in which a means (18) is provided for detecting a polarity (+/-) of the direct current component of the output voltage (4), wherein the current transformer (100) is arranged to multiply the effective value (5) by a positive or negative factor, depending on the detected polarity (+/-) of the output voltage (4) of the current sensor, wherein the positive factor is also chosen in case of a pure alternating current as the conductor current (1, $I_{LOAD}$), and to output the signed effective value (5) as an output signal (2, $U_{OUT}$ / $I_{OUT}$).

**2.** Current transformer (100) according to claim 1, **characterized in that** the first processing branch (I) comprises a first frequency filter (11), especially for filtering of high-frequency interference signals.

**3.** Current transformer (100) according to one of the preceding claims, **characterized in that** the second processing branch (II) comprises a second frequency filter (17), especially for smoothing out the output signal (4).

**4.** Current transformer (100) according to one of the preceding claims, **characterized in that** it comprises an output circuit (19) for converting the signed effective value (5') into the output signal (2, $U_{OUT}$ / $I_{OUT}$).

**5.** Current transformer (100) according to one of the preceding claims, **characterized in that** the output signal (2, $U_{OUT}$ / $I_{OUT}$) is a voltage signal or a current signal.

**6.** Current transformer (100) according to claim 4 or 5, **characterized in that** the output circuit (19) comprises a means (14) of adding an offset value (6, $I_{OUT/OFF}$) and/or a means (15) of scaling the output signal (2, $U_{OUT}$ / $I_{OUT}$).

**7.** Current transformer (100) according to claim 6, **characterized in that** the offset value (6, $I_{OUT/OFF}$) is larger than half of a value region being plotted.

**8.** Current transformer (100) according to one of the preceding claims, wherein a time constant used during the calculation of the effective value (5) in the means (12) is adjustable.

**9.** Current transformer (100) according to one of the preceding claims, wherein the current sensor is a Hall sensor (10) or a shunt resistor.

**10.** Method for converting a conductor current (1, $I_{LOAD}$) flowing in an electrical conductor into an output signal (2, $U_{OUT}$ / $I_{OUT}$) by using a current transformer (100) comprising a current sensor that is used for detecting the conductor current (1, $I_{LOAD}$) and for transforming the conductor current (1, $I_{LOAD}$) into a proportional output voltage (4), wherein the current transformer (100)

- calculates the effective value (5) of the output voltage (4) of the current sensor,
- the polarity (+/-) of the direct current component of the output voltage (4) of the current sensor is detected, and
- the calculated effective value (5) is multiplied, depending on the polarity (+/-) detected, with a positive or a negative factor to form a signed effective value (5'), wherein the positive factor is also chosen in case of a pure alternating current as the conductor current (1, $I_{LOAD}$), and
- an output signal (2, $U_{OUT}$ / $I_{OUT}$) is put out corresponding to the signed effective value (5').

**11.** Method according to claim 10, **characterized in that** the signed effective value (5') for determining the output signal (2, $U_{OUT}$ / $I_{OUT}$) is scaled, and/or an offset value (6, $I_{OUT/OFF}$) is added to the signed effective value (5').

**Revendications**

**1.** Convertisseur de courant (100) comprenant un capteur de courant qui est prévu pour convertir un courant de conducteur (1, $I_{LOAD}$) qui circule dans un conducteur électrique en une tension de sortie (4) proportionnelle au courant de conducteur (1, $I_{LOAD}$), **caractérisé en ce que**
le convertisseur de courant (100) comprend une première branche de traitement (I) dans laquelle est prévu un moyen (12) pour calculer la valeur efficace (5) de la tension de sortie (4), ainsi qu'une deuxième branche de traitement (II) dans laquelle est prévu un moyen (18) pour détecter une polarité (+/-) de la composante de courant continu de la tension de sortie (4), le convertisseur de courant (100) étant conçu pour multiplier la valeur efficace (5) par un facteur positif ou négatif en fonction de la polarité détectée (+/-) de la tension de sortie (4) du capteur de courant, dans lequel, dans le cas d'un courant alternatif pur comme courant de conducteur (1, $I_{LOAD}$), le facteur positif est également choisi, et la valeur efficace signée (5') est délivrée en tant que signal de sortie (2, $U_{OUT}$ / $I_{OUT}$).

**2.** Convertisseur de courant (100) selon la revendication 1, **caractérisé en ce que** la première branche de traitement (I) comprend un premier filtre de fréquences (11), en particulier pour filtrer les signaux parasites à haute fréquence.

**3.** Convertisseur de courant (100) selon l'une des revendications précédentes, **caractérisé en ce que** la deuxième branche de traitement (II) comprend un deuxième filtre de fréquences (17), en particulier pour lisser le signal de sortie (4).

**4.** Convertisseur de courant (100) selon l'une des revendications précédentes, **caractérisé en ce qu'**il comprend un circuit de sortie (19) pour convertir la valeur efficace signée (5') en signal de sortie (2, $U_{OUT}$ / $I_{OUT}$).

**5.** Convertisseur de courant (100) selon l'une des revendications précédentes, **caractérisé en ce que** le signal de sortie (2, $U_{OUT}$ / $I_{OUT}$) est un signal de tension ou un signal de courant.

**6.** Convertisseur de courant (100) selon la revendication 4 ou 5, **caractérisé en ce que** le circuit de sortie (19) comprend un moyen (14) pour ajouter une valeur de décalage (6, $I_{OUT/OFF}$) et/ou un moyen (15) pour mettre à l'échelle le signal de sortie (2, $U_{OUT}$ / $I_{OUT}$).

**7.** Convertisseur de courant (100) selon la revendication 6, **caractérisé en ce que** la valeur de décalage (6, $I_{OUT/OFF}$) est supérieure à la moitié d'une plage de valeurs à représenter.

**8.** Convertisseur de courant (100) selon l'une des revendications précédentes, dans lequel une constante de temps utilisée dans le moyen (12) pour le calcul de la valeur efficace (5) est réglable.

**9.** Convertisseur de courant (100) selon l'une des revendications précédentes, dans lequel le capteur de courant est un capteur à effet Hall (10) ou une résistance shunt.

**10.** Procédé pour convertir un courant de conducteur (1, $I_{LOAD}$) circulant dans un conducteur électrique en un signal de sortie (2, $U_{OUT}$ / $I_{OUT}$), en utilisant un convertisseur de courant (100) comprenant un capteur de courant, le capteur de courant étant utilisé pour détecter le courant de conducteur (1, $I_{LOAD}$) et pour convertir le courant de conducteur (1, $I_{LOAD}$) en une tension de sortie proportionnelle (4), dans lequel le convertisseur de courant (100)

- calcule la valeur efficace (5) de la tension de sortie (4) du capteur de courant,
- détecte la polarité (+/-) de la composante de courant continu de la tension de sortie (4) du capteur de courant, et

- multiplie la valeur efficace calculée (5) par un facteur positif ou négatif en fonction de la polarité détectée (+/) pour former une valeur efficace signée (5'), dans lequel, dans le cas d'un courant alternatif pur comme courant de conducteur (1, $I_{LOAD}$), le facteur positif est également choisi, et

- un signal de sortie (2, $U_{OUT}$ / $I_{OUT}$) correspondant à la valeur efficace signée (5') est délivré.

11. Procédé selon la revendication 10, **caractérisée en ce que** la valeur efficace signée (5') est mise à l'échelle pour déterminer le signal de sortie (2, $U_{OUT}$ / $I_{OUT}$) et/ou une valeur de décalage (6, $I_{OUT/OFF}$) est ajoutée à la valeur efficace signée (5').

Fig. 1a    (Stand der Technik)

Fig. 1b    (Stand der Technik)

Fig. 2

Fig. 3

EP 2 981 834 B1